# EUROPÄISCHE PATENTSCHRIFT

(11) **EP 3 633 724 B1**
(45) Veröffentlichungstag und Bekanntmachung des Hinweises auf die Patenterteilung: **21.04.2021**
(21) Anmeldenummer: 19199720.4
(22) Anmeldetag: 26.09.2019
(51) Int. Cl.: H01L 27/10, H01L 29/66, H01L 29/94, H01L 21/78, H01L 23/64, H01L 27/02

(54) **VERFAHREN ZUR HERSTELLUNG VON HALBLEITERKONDENSATOREN UNTERSCHIEDLICHER KAPAZITÄTSWERTE IN EINEM HALBLEITERSUBSTRAT**
METHOD FOR PRODUCING SEMICONDUCTOR CAPACITORS OF DIFFERENT CAPACITANCE VALUES IN A SEMICONDUCTOR SUBSTRATE
PROCÉDÉ DE FABRICATION DE CONDENSATEURS À SEMI-CONDUCTEURS DE DIFFÉRENTES CAPACITÉS DANS UN SUBSTRAT À SEMI-CONDUCTEUR

(30) Priorität: 04.10.2018 DE 102018217001
(43) Veröffentlichungstag der Anmeldung: 08.04.2020
(73) Patentinhaber: Fraunhofer-Gesellschaft zur Förderung der angewandten Forschung e.V., 80686 München (DE)
(72) Erfinder: ERLBACHER, Tobias, 91058 Erlangen (DE)
(74) Vertreter: Gagel, Roland

(56) Entgegenhaltungen:
- US-A- 5 747 841
- US-A1- 2010 330 766
- US-A1- 2011 090 615

## Beschreibung

### Technisches Anwendungsgebiet

Die vorliegende Erfindung betrifft ein Verfahren zur Herstellung von Halbleiterkondensatoren mit unterschiedlichen Kapazitätswerten in einem Halbleitersubstrat, insbesondere zur Durchführung in einem Foundry-Prozess.

Viele Halbleiterbauelemente werden gerade in kleineren Stückzahlen häufig durch Auftragsfertigung in Halbleiterwerken, sog. Foundries, gefertigt. Aufgrund der kleinen Stückzahlen müssen dabei üblicherweise Halbleiterbauelemente mit unterschiedlichen Spezifikationen auf dem gleichen Halbleitersubstrat hergestellt werden. Dies erfordert eine Festlegung des gesamten Maskendesigns für die unterschiedlichen Halbleiterbauelemente vor Beginn der Fertigung, die erst nach dieser Festlegung beginnen kann.

### Stand der Technik

So zeigt bspw. die US 7738226 B2 einen Aufbau eines RC-Snubberglieds, das mittels konventioneller Chipfertigung hergestellt wird. Die Herstellung derartiger Snubberglieder erfordert eine Definition des Maskendesigns inkl. Sägestraßen, Metallflächen usw. vor der Herstellung. Der Kapazitäts- und der Widerstandswert des RC-Snubberglieds müssen dabei also bereits vor Beginn des Fertigungsprozesses festliegen.

Die US 8563388 B2 zeigt ein Fertigungsverfahren für RC-Snubberglieder, bei dem zunächst eine gleichmäßige Lochstruktur in dem Halbleitersubstrat erzeugt und mit einer dielektrischen Schicht verfüllt wird, die sich auch zwischen den einzelnen Löchern erstreckt. Auf eine Abgrenzung zwischen einzelnen herzustellenden Kondensatoren bzw. RC-Snubbergliedern wird in dieser ersten Herstellungsphase verzichtet. Erst anschließend werden in einer zweiten Herstellungsphase durch Aufbringen einer strukturierten Metallisierung die Kapazitätswerte der einzelnen Kondensatoren und damit auch die Begrenzungen dieser Kondensatoren auf dem Halbleitersubstrat festgelegt. Abschließend erfolgt dann eine Vereinzelung der einzelnen Kondensatoren bzw. RC-Snubberglieder, bei der die Trennlinien dann zum Teil durch vorhandene Löcher verlaufen

Die US 2011/090615 A1 lehrt die Herstellung laminierter Halbleiterkapazitäten in Form einer Vielzahl von Kapazitätselementen, einschließlich der Bereitstellung von Trennbereichen zwischen diesen Elementen sowie deren Vereinzelung.

### Darstellung der Erfindung

Die Aufgabe der vorliegenden Erfindung besteht darin, ein Verfahren zur Herstellung von Halbleiterkondensatoren unterschiedlicher Kapazitätswerte auf einem gemeinsamen Halbleitersubstrat anzugeben, das eine kostengünstige Fertigung von Kondensatoren oder auch RC-Snubbergliedern mit kundenspezifischen elektrischen Eigenschaften ermöglicht.

Die Aufgabe wird mit dem Verfahren gemäß Patentanspruch 1 gelöst. Vorteilhafte Ausgestaltungen des Verfahrens sind Gegenstand der abhängigen Patentansprüche oder lassen sich der nachfolgenden Beschreibung sowie den Ausführungsbeispielen entnehmen.

Das vorgeschlagene Verfahren zur Herstellung von Halbleiterkondensatoren mit unterschiedlichen Kapazitätswerten in einem niederohmigen Halbleitersubstrat ist in zwei Herstellungsphasen unterteilt. In der ersten Herstellungsphase werden unabhängig von den im Halbleitersubstrat herzustellenden Halbleiterkondensatoren mehrere Gruppen von Löchern in dem Halbleitersubstrat erzeugt, die über das Halbleitersubstrat verteilt und jeweils durch erkennbare Trennbereiche voneinander getrennt sind. Die Trennbereiche weisen eine Breite (Abstand zwischen den jeweiligen Gruppen) auf, die größer als der Abstand der Löcher innerhalb der Gruppen, also insbesondere größer als 5 µm, ist. Diese Lochstruktur wird wiederum unabhängig von den in dem Halbleitersubstrat herzustellenden Halbleiterkondensatoren mit einer Schichtfolge aus einem Dielektrikum und einer elektrisch leitfähigen Schicht, bspw. aus einem Metall oder aus Polysilizium, als späterer oberer Elektrode der Halbleiterkondensatoren verfüllt, wobei sich diese Schichtfolge auch zwischen den Löchern und Gruppen von Löchern erstreckt. Jede Gruppe von Löchern bildet durch diese Schichtfolge eine Kapazität, im Folgenden zur Unterscheidung gegenüber der Kapazität des herzustellenden Halbleiterkondensators als erste Kapazität bezeichnet. Mit diesem dadurch erhaltenen Halbzeug, dem teilprozessierten Halbleitersubstrat mit der Lochstruktur und der Beschichtung, wird dann die zweite Herstellungsphase durchgeführt, in der erst die in dem Halbleitersubstrat herzustellenden Halbleiterkondensatoren festgelegt werden. Dies erfolgt durch Einteilung des Halbleitersubstrats in unterschiedliche Teilbereiche, in denen jeweils Halbleiterkondensatoren mit identischen Kapazitätswerten hergestellt werden. Die Kapazitätswerte der Halbleiterkondensatoren der unterschiedlichen Teilbereiche unterscheiden sich dabei. Die in der ersten Herstellungsphase aufgebrachte Schichtfolge wird dann strukturiert und eine Metallisierung strukturiert aufgebracht oder aufgebracht und anschließend strukturiert. Die Strukturierung der Schichtfolge und das Aufbringen und/oder Strukturieren der Metallisierung erfolgen dabei so, dass in jedem Teilbereich die Halbleiterkondensatoren mit dem gewünschten Kapazitätswert entweder jeweils durch eine der ersten Kapazitäten selbst, falls diese bereits dem gewünschten Kapazitätswert entsprechen, oder durch elektrisch parallele Verbindung einer geeigneten Anzahl der ersten Kapazitäten erhalten werden. Die Strukturierung der Schichtfolge kann dabei auch lediglich eine Strukturierung der elektrisch leitfähigen Schicht der Schichtfolge umfassen. Unter einer Strukturierung wird in diesem Zusammenhang eine Auftrennung der jeweiligen Schicht in unterschiedliche, voneinander getrennte Bereiche verstanden, beispielsweise durch Wegätzen von Bereichen der Schicht. Erst für diese zweite Herstellungsphase müssen somit die elektrischen Eigenschaften bzw. Kapazitätswerte sowie die Anzahl der mit einem jeweiligen Kapazitätswert auf dem Halbleitersubstrat herzustellenden Halbleiterkondensatoren festgelegt werden. Die Halbleiterkondensatoren jedes Teilbereichs werden dann durch Auftrennen des Halbleitersubstrats entlang von Trennlinien vereinzelt, die innerhalb der in der ersten Herstellungsphase festgelegten Trennbereiche verlaufen. Selbstverständlich lassen sich in der zweiten Herstellungsphase vor der Vereinzelung bei Bedarf auch weitere Schichten auf das Halbleitersubstrat aufbringen.

Durch diese Auftrennung des Herstellungsprozesses in die beiden Herstellungsphasen in Verbindung mit der Nutzung der vorhandenen Trennbereiche wird eine effiziente und kostengünstige Fertigung von Halbleiterkondensatoren mit unterschiedlichen Kapazitätswerten in dem Herstellungsprozess erreicht, ohne die Kapazitätswerte der Kondensatoren bereits vor Beginn des Herstellungsprozesses festlegen zu müssen. Insbesondere lässt sich mit dem vorgeschlagenen Verfahren die Auftragsfertigung in einer Foundry kostengünstiger realisieren, da bereits unabhängig von den eingehenden Aufträgen eine Vielzahl von Halbzeugen (teilprozessierte Halbleitersubstrate) mit den Verfahrensschritten der ersten Herstellungsphase hergestellt werden kann. Da sich hierbei die Verfahrensschritte von Halbzeug zu Halbzeug nicht unterscheiden, lässt sich diese Herstellung sehr kostengünstig durchführen. Die Fertigstellung der Bauteile mit den kundenspezifischen elektrischen Eigenschaften (Individualisierung) erfolgt dann erst in der zweiten Herstellungsphase, bei der die vorher hergestellten Halbzeuge eingesetzt werden. Durch die vorangehende Festlegung von Trennbereichen in der ersten Herstellungsphase wird bei der späteren Vereinzelung eine Beschädigung der Bauteile vermieden, da keine Löcher unmittelbar im Anschluss an die aktiven Bereiche durchtrennt werden müssen.

Die Trennbereiche werden in der ersten Herstellungsphase dabei vorzugsweise so gewählt, dass sie sich jeweils geradlinig über das gesamte Halbleitersubtrat erstrecken. In diesen Trennbereichen werden in einer bevorzugten Ausgestaltung des vorgeschlagenen Verfahrens in der ersten Herstellungsphase auch Löcher oder Vertiefungen erzeugt, die zur Stressmigration durch Minimierung der planaren Oberfläche des Halbleitersubstrats ausgebildet sind. Dadurch werden bei Abscheidung dickerer Schichten oder Schichtfolgen auf dem Halbleitersubstrat Spannungen zwischen der Schicht und dem Halbleitersubstrat reduziert. Die Löcher oder Vertiefungen sind dabei so angeordnet oder ausgebildet, dass die Trennbereiche gegenüber den Gruppen von Löchern erkennbar bleiben. Dies kann durch andere Dimensionierung oder Abstände der Löcher dieser Trennbereiche oder auch durch Einhaltung eines erkennbaren Abstandes zwischen den Löchern der Trennbereiche und den Löchern der einzelnen Gruppen erfolgen.

Mit dem vorgeschlagenen Verfahren lassen sich auch RC-Snubberglieder herstellen wie sie beispielsweise aus der bereits genannten US 7738226 B2 bekannt sind. Hierzu wird das Halbleitersubstrat vor der Vereinzelung in einer vorgeschlagenen Ausgestaltung mit einem zweiten Halbleitersubstrat verbunden, das durch eine geringere Dotierung einen höheren Flächenwiderstand als das Halbleitersubstrat mit den Halbleiterkondensatoren aufweist. Vorzugsweise erfolgt anschließend noch eine Metallisierung der freien Seite dieses zweiten Halbleitersubstrates. Durch die Verbindung mit dem zweiten Halbleitersubstrat wird jeweils eine Reihenschaltung aus einem Halbleiterkondensator und einem durch das zweite Halbleitersubstrat festgelegten Widerstand gebildet. Anschließend erfolgt wiederum die Vereinzelung dieses Halbleiterstapels zur Bildung der einzelnen RC-Snubberglieder.

In einer alternativen Ausgestaltung kann das Halbleitersubstrat zur Herstellung von RC-Snubbergliedern vor der Vereinzelung auch mit einer rückseitigen Schicht versehen werden, die einen höheren Flächenwiderstand als das Halbleitersubstrat mit den Halbleiterkondensatoren aufweist. Auch bei dieser Ausgestaltung erfolgt dann - vorzugsweise wiederum nach Aufbringen einer rückseitigen Metallisierung - die anschließende Vereinzelung zur Bildung der einzelnen RC-Snubberglieder.

### Kurze Beschreibung der Zeichnungen

Das vorgeschlagene Verfahren wird nachfolgend anhand von Ausführungsbeispielen in Verbindung mit den Zeichnungen nochmals erläutert. Hierbei zeigen:
- Fig. 1: ein Beispiel für den Aufbau eines Halbleiterkondensators, wie er mit dem vorgeschlagenen Verfahren herstellbar ist;
- Fig. 2: eine schematische Darstellung einer Verteilung der Gruppen von Löchern über das Halbleitersubstrat gemäß dem vorgeschlagenen Verfahren;
- Fig. 3: eine vergrößerte Darstellung eines Ausschnitts aus der Figur 2 gemäß einer ersten Ausgestaltung;
- Fig. 4: eine vergrößerte Darstellung eines Ausschnitts aus Figur 2 gemäß einer zweiten Ausgestaltung; und
- Fig. 5: eine stark schematisierte Darstellung der Verbindung mit einem zweiten Halbleitersubstrat zur Herstellung von RC-Snubbergliedern.

### Wege zur Ausführung der Erfindung

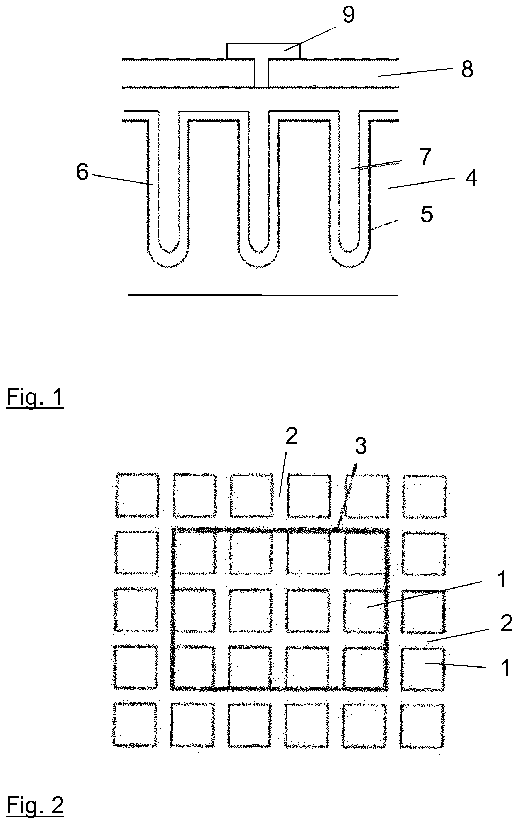

Mit dem vorgeschlagenen Verfahren lassen sich Halbleiterkondensatoren, insbesondere Siliziumkondensatoren, mit verschiedenen elektrischen Kenngrößen auf einem gemeinsamen Halbleitersubstrat herstellen, wobei in einer ersten Herstellungsphase ein teilprozessiertes Halbleitersubstrat als Halbzeug erzeugt wird, das unabhängig von den unterschiedlichen elektrischen Kenngrößen bzw. Kapazitätswerten der herzustellenden Halbleiterkondensatoren aufgebaut ist. Mit dem Verfahren lassen sich bspw. Halbleiterkondensatoren herstellen, wie sie beispielhaft in Figur 1 dargestellt sind, oder auch RC-Snubberglieder, die derartige Halbleiterkondensatoren aufweisen.

In Figur 1 ist ein Abschnitt eines Halbleitersubstrats 4 im Querschnitt dargestellt, in dessen Oberfläche eine Lochstruktur mit Löchern 5 geätzt wird, die als Basis für den herzustellenden Kondensator dient. Das Halbleitersubtrat 4 weist eine hohe Dotierung, beispielsweise eine Bor-Dotierung, von wenigstens 5*10¹⁸ cm⁻³ und somit einen geringen ESR (äquivalenter Serienwiderstand) auf. Die Erzeugung der Löcher 5 kann durch bekannte Masken- und Ätztechnik erfolgen. Die Löcher 5 werden dann mit einer Schichtfolge aus einem Dielektrikum 6 und einem Metall 7 verfüllt, das die obere Elektrode des Kondensators bildet. Es folgt die Abscheidung einer Isolationsschicht 8 sowie einer weiteren Metallisierung 9, die für die vorderseitige Kontaktierung des Halbleiterkondensators dient. Die Rückseite des Halbleitersubstrats 4 kann ebenfalls mit einer entsprechenden Metallisierung versehen werden. Der Kapazitätswert des auf diese Weise hergestellten Halbleiterkondensators hängt dabei u.a. auch von der Anzahl der Löcher 5 bzw. der Flächengröße der Lochstruktur ab. Bisher wird zur Herstellung derartiger Halbleiterkondensatoren ein übliches Chip-Fertigungsverfahren eingesetzt, bei dem die Definition des Maskendesigns für die herzustellenden Kondensatoren vor Beginn der Fertigung festliegt, so dass auch die Kapazitätswerte der einzelnen Kondensatoren vor Beginn der Fertigung bekannt sein müssen.

Mit dem vorliegenden Verfahren ist diese Festlegung vor Beginn des Herstellungsprozesses nicht mehr erforderlich. Vielmehr können Halbzeuge in großer Zahl zunächst mit exakt gleichen Strukturen hergestellt werden. Die Fertigung von Halbleiterkondensatoren mit unterschiedlichen Kapazitätswerten auf dem gleichen Halbleitersubstrat erfolgt dann unter Verwendung dieser Halbzeuge.

Hierzu wird beim vorgeschlagenen Verfahren in einer ersten Herstellungsphase, in der das Halbzeug hergestellt wird, eine Lochstruktur mit Löchern in dem Halbleitersubstrat erzeugt, die sich über das gesamte Halbleitersubstrat erstrecken. Diese Löcher werden bei dem vorgeschlagenen Verfahren in voneinander getrennten Gruppen mit einer Masken- und Ätztechnik in dem Halbleitersubstrat erzeugt, wobei jede Gruppe nach der anschließenden Abscheidung einer Schichtfolge aus Dielektrikum und Metall eine Kapazität bildet, hier zur Unterscheidung gegenüber der Kapazität des herzustellenden Halbleiterkondensators als erste Kapazität bezeichnet.

Figur 2 zeigt hierzu in stark schematisierter Darstellung eine Draufsicht auf einen Abschnitt des Halbleitersubstrats 4, in dem die einzelnen Gruppen 1 von Löchern eine annähernd quadratische Fläche einnehmen und durch die kleinen Quadrate in der Figur angedeutet sind. Die Gruppen 1 von Löchern können auch anderen geometrischen Formen, bspw. Rechtecken oder Dreiecken angenähert sein. Aus der Figur 2 ist ebenfalls ersichtlich, dass zwischen den einzelnen Gruppen 1 Trennbereiche 2 vorhanden sind, die die einzelnen Gruppen 1 voneinander abtrennen und später als Sägestraßen bei der Vereinzelung der Halbleiterkondensatoren dienen. Nach der Herstellung der Lochstruktur wird eine Schichtfolge aus einem Dielektrikum und einem Metall auf dem Halbleitersubstrat abgeschieden, mit der die Löcher in der bekannten Weise verfüllt werden. Diese Schichtfolge wird über das gesamte Halbleitersubstrat 4, also auch über die Trennbereiche 2 zwischen den einzelnen Gruppen 1 aufgebracht, ist also unabhängig von den später herzustellenden Kapazitätswerten der Kondensatoren.

Mit dem auf diese Weise erhaltenen teilprozessierten Halbleitersubstrat, in der vorliegenden Patentanmeldung auch als Halbzeug bezeichnet, wird dann die zweite Herstellungsphase durchgeführt, in der die einzelnen Halbleiterkondensatoren mit den gewünschten Kapazitätswerten erhalten werden. Hierzu werden Teilbereiche 3 festgelegt, innerhalb derer jeweils eine Anzahl von Halbleiterkondensatoren mit identischen Kapazitätswerten erzeugt werden soll. Die Größe dieser Teilbereiche 3 hängt von der Anzahl und dem Kapazitätswert der herzustellenden Halbleiterkondensatoren ab. In Figur 2 ist nur schematisch ein derartiger Teilbereich 3 angedeutet. Andere Teilbereiche betreffen dann wiederum Halbleiterkondensatoren mit anderen Kapazitätswerten. In den jeweiligen Teilbereichen 3 werden dann in der zweiten Herstellungsphase durch Metallisierung und Strukturierung Halbleiterkondensatoren hergestellt, die die erforderliche Anzahl an Gruppen 1 von Löchern für die gewünschte Kapazität aufweisen. Hierzu werden durch die Strukturierung und Metallisierung die einzelnen ersten Kapazitäten der Gruppen 1 von Löchern in geeigneter Anzahl parallel geschaltet. Dies erfordert ein auf den jeweiligen Kapazitätswert abgestimmtes Maskendesign. Anschließend erfolgt dann die Vereinzelung der einzelnen Kondensatoren in dem entsprechenden Teilbereich 3 entlang der Trennbereiche 2.

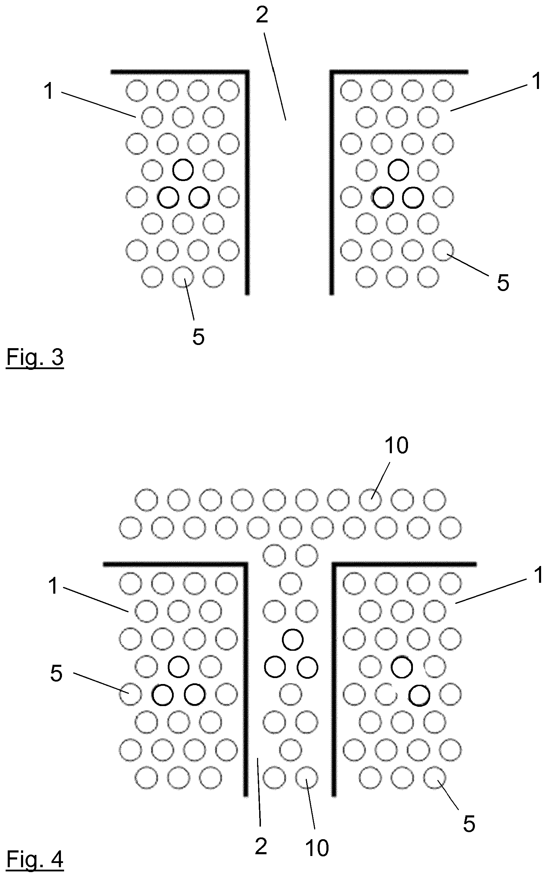

Figur 3 zeigt hierzu nochmals eine vergrößerte Darstellung eines Ausschnitts aus Figur 2, in der die einzelnen Löcher 5 der Gruppen 1 erkennbar sind. Die Trennbereiche 2 zwischen Lochstrukturen 1 weisen hier keine Löcher auf.

In einer weiteren Ausgestaltung können jedoch auch entsprechende Vertiefungen oder Löcher in den Trennbereichen 2 erzeugt werden, wie dies in Figur 4 schematisch dargestellt ist. Die Löcher 10 in diesen Trennbereichen 2 sind in diesem Beispiel durch einen entsprechend vergrößerten Abstand zu den Gruppen 1 von Löchern 5 so angeordnet, dass noch immer die einzelnen Trennbereiche 2 und Gruppen 1 von Löchern erkennbar sind. Durch diese zusätzlichen Löcher 10 in den Trennbereichen 2 wird eine Stressmigration erreicht, so dass Spannungen beim Aufbringen dickerer Schichten auf das Halbleitersubstrat zwischen den Schichten und dem Halbleitersubstrat in diesem Bereich verringert werden.

Durch die Lochstrukturierung und die Verfüllung mit einem Dielektrikum und einem Metall als oberer Elektrode in der ersten Herstellungsphase mit einem festdefinierten Maskendesign, das unabhängig von den später herzustellenden Halbleiterkondensatoren ist, kann das Halbzeug unabhängig von den herzustellenden Halbleiterkondensatoren in großer Menge kostengünstig hergestellt werden. Die Individualisierung bzw. Herstellung der Halbleiterkondensatoren mit unterschiedlichen Kapazitätswerten erfolgt dann erst in der zweiten Herstellungsphase. In dieser zweiten Herstellungsphase werden das Dielektrikum und/oder die obere Elektrode strukturiert und eine Metallisierung über einen Teil der Einzelbereiche bzw. Gruppen hinweg erzeugt, um die Halbleiterkondensatoren mit den entsprechenden Kapazitätswerten zu bilden. Dies erfolgt dann mit einem jeweils individuell definierten Maskendesign.

Durch die Parallelverschaltung der Lochstrukturen mehrerer der Gruppen 1 können somit unterschiedlichste Kapazitätswerte erhalten werden. So kann bspw. das Halbzeug durch Prozessierung auf einem niederohmigen p-Substrat erzeugt werden. Die Dimensionierung der Fläche der Gruppen 1 kann dabei bspw. so erfolgen, dass bei einer Fläche jeder Gruppe 1 von 0,5 mm² und einem ersten Kapazitätswert dieser Gruppe von 250 pF durch Parallelverschaltung mehrerer der Gruppen Kapazitätswerte C von 1 bis 10 nF erhalten werden können. Dies ist in der nachfolgenden Tabelle dargestellt, die die Gesamtfläche A sowie die Anzahl der jeweils parallel verschalteten Gruppen 1 zeigt.

| | | | | | | | |
|---|---|---|---|---|---|---|---|
| C in nF | 1 | 1,5 | 3,0 | 4,5 | 5,0 | 5,5 | 10 |
| A i n mm² | 2 | 3 | 6 | 9 | 10 | 12 | 20 |
| Anzahl Gruppen | 4 | 6 | 12 | 18 | 20 | 24 | 40 |

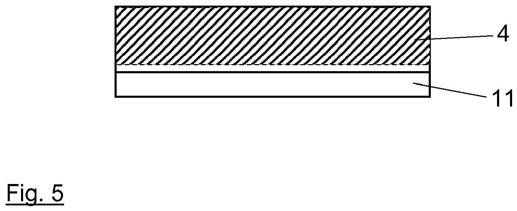

Das vorgeschlagene Verfahren eignet sich auch für die Herstellung von RC-Snubbergliedern. Hierbei muss zusätzlich zu den Halbleiterkondensatoren der entsprechende Widerstand erzeugt werden. Dies kann bei dem vorgeschlagenen Verfahren dadurch erfolgen, dass das Halbleitersubstrat 4 mit den Lochstrukturen vor der Vereinzelung in die einzelnen Bauteile auf ein niedriger dotiertes Halbleitersubstrat 11 gebondet wird, wie dies in Figur 5 stark schematisiert dargestellt ist. In dieser Figur ist der Bereich mit dem Lochstrukturen lediglich schraffiert angedeutet. Die Dotierung dieses zweiten Halbleitersubstrates wird dabei so gewählt, dass der gewünschte Widerstandswert erreicht wird. Die nachfolgende Tabelle zeigt hierbei Beispiele des seriellen Widerstands R_{ESR} für verschiedene zweite Substrate (z.B. 400 µm dick) mit unterschiedlichem spezifischem Widerstand p bei 5 nF/10mm². Der erste Wert entspricht den Verhältnissen ohne ein zweites Substrat (nur Kondensator).

| | | | | | | | |
|---|---|---|---|---|---|---|---|
| ρ in Ωcm | 0 | 0,5 | 1,0 | 3,0 | 10 | 30 | 100 |
| R_{ESR} in Ω | 0,1 | 0,3 | 0,5 | 1,3 | 4,1 | 12 | 40 |

Eine weitere Möglichkeit zur Herstellung von RC-Snubbergliedern besteht in der Abscheidung einer schlecht leitfähigen Schicht - je nach benötigtem Serienwiderstand - auf der Rückseite des Halbleitersubstrats vor der Vereinzelung in die einzelnen Bauteile. Hier besteht auch die Möglichkeit, die Temperaturabhängigkeit des Widerstands gezielt zu wählen oder ein Mehrschichtsystem zur Kondensation der Temperaturabhängigkeit abzuscheiden. Beispiele für geeignete Schichtmaterialien sind Keramiken, Metallschichten, amorphes Silizium usw. mit hoher Wärmeleitfähigkeit. Die folgende Tabelle gibt hierbei wiederum Beispiele des seriellen Widerstands R_{ESR} für verschiedene Schichten (z.B. 4 µm dick) mit unterschiedlichem spezifischem Widerstand p bei 5nF/10mm² an. Der erste Wert entspricht wieder den Verhältnissen ohne die zusätzliche Widerstandsschicht (nur Kondensator).

| | | | | | | | |
|---|---|---|---|---|---|---|---|
| ρ in Ωcm | 0 | 50 | 100 | 300 | 1k | 3k | 10k |
| R_{ESR} in Ω | 0,1 | 0,3 | 0,5 | 1,3 | 4,1 | 12 | 40 |

### Bezugszeichenliste

1 Gruppe von Löchern
2 Trennbereiche
3 Teilbereiche
4 Halbleitersubstrat
5 Löcher
6 Dielektrikum
7 Metall
8 Isolationsschicht
9 Metallisierung
10 Weitere Löcher
11 Zweites Halbleitersubstrat

## Patentansprüche

1. Verfahren zur Herstellung von Halbleiterkondensatoren mit unterschiedlichen Kapazitätswerten in einem Halbleitersubstrat, bei dem
- in einer ersten Herstellungsphase unabhängig von den in dem Halbleitersubstrat (4) herzustellenden Halbleiterkondensatoren:
-- eine Lochstruktur aus mehreren Gruppen (1) von Löchern (5) in dem Halbleitersubstrat (4) erzeugt wird, die über das Halbleitersubstrat (4) verteilt und jeweils über erkennbare Trennbereiche (2) mit einer Breite voneinander getrennt sind, die größer als ein Abstand der Löcher (5) innerhalb der Gruppen (1) ist,
wobei die Trennbereiche (2) entweder keine Löcher aufweisen oder in den Trennbereichen (2) weitere Lochstrukturen (10) unter Einhaltung eines erkennbaren Abstandes zwischen den Löchern der Trennbereiche (2) und den Löchern (5) der einzelnen Gruppen (1) erzeugt werden, so dass die Trennbereiche (2) gegenüber den Gruppen (1) von Löchern (5) erkennbar bleiben, und
-- die Lochstruktur mit einer Schichtfolge aus einem Dielektrikum (6) und einer elektrisch leitfähigen Schicht (7) als oberer Elektrode des herzustellenden Halbleiterkondensators verfüllt wird, wobei sich die Schichtfolge auch zwischen den Löchern (5) und Gruppen (1) erstreckt und jede der Gruppen (1) eine erste Kapazität bildet, und
- in einer zweiten Herstellungsphase in Abhängigkeit von den in dem Halbleitersubstrat (4) herzustellenden Halbleiterkondensatoren:
-- unterschiedliche Teilbereiche (3) des Halbleitersubstrates (4) festgelegt werden, in denen jeweils Halbleiterkondensatoren mit identischen Kapazitätswerten der ersten Kapazität hergestellt werden, wobei sich die gewünschten Kapazitätswerte der Halbleiterkondensatoren der unterschiedlichen Teilbereiche (3) voneinander unterscheiden,
-- die Schichtfolge strukturiert und eine Metallisierung (9) strukturiert aufgebracht oder aufgebracht und anschließend strukturiert wird, wobei die Strukturierung und die Aufbringung der Metallisierung so erfolgen, dass innerhalb jedes Teilbereiches (3) die Halbleiterkondensatoren in Abhängigkeit der gewünschten Kapazitätswerte entweder jeweils durch eine der ersten Kapazitäten oder durch elektrisch parallele Verbindung mehrerer der ersten Kapazitäten gebildet werden, und
-- die Halbleiterkondensatoren jedes Teilbereichs (3) durch Auftrennen des Halbleitersubstrats (4) entlang von Trennlinien vereinzelt werden, die innerhalb der Trennbereiche (2) verlaufen.

2. Verfahren nach Anspruch 1,
**dadurch gekennzeichnet,**
**dass** sich die Trennbereiche (2) geradlinig über das gesamte Halbleitersubstrat (4) erstrecken.

3. Verfahren nach Anspruch 1 oder 2,
**dadurch gekennzeichnet,**
**dass** in der ersten oder zweiten Herstellungsphase jeweils rückseitig eine Metallisierung auf das Halbleitersubstrat (4) aufgebracht wird.

4. Verfahren nach einem der Ansprüche 1 bis 3,
**dadurch gekennzeichnet,**
**dass** das Halbleitersubstrat (4) vor der Vereinzelung der Halbleiterkondensatoren mit einem zweiten Halbleitersubstrat (11) verbunden wird, das durch eine geringere Dotierung einen höheren Flächenwiderstand als das Halbleitersubstrat (4) aufweist, so dass durch die Vereinzelung RC-Glieder erhalten werden.

5. Verfahren nach einem der Ansprüche 1 bis 3,
**dadurch gekennzeichnet,**
**dass** das Halbleitersubstrat (4) vor der Vereinzelung der Halbleiterkondensatoren mit einer rückseitigen Schicht oder Schichtfolge versehen wird, die einen höheren Flächenwiderstand als das Halbleitersubstrat (4) aufweist, so dass durch die Vereinzelung RC-Glieder erhalten werden.

6. Verfahren nach Anspruch 4 oder 5,
**dadurch gekennzeichnet,**
**dass** in der zweiten Herstellungsphase rückseitig eine Metallisierung auf das zweite Halbleitersubstrat oder die rückseitige Schicht aufgebracht wird.

## Claims

1. A method for producing semiconductor capacitors having different capacitance values in a semiconductor substrate in which
- in a first production phase independently of the semiconductor capacitors to be produced in the semiconductor substrate (4):
-- a hole structure comprising several groups (1) of holes (5) is produced in the semiconductor substrate (4), which groups are distributed over the semiconductor substrate (4) and in each case are separated from one another by means of identifiable dividing regions (2) having a width which is greater than the spacing of the holes (5) within the groups (1),
wherein the dividing regions (2) either do not have holes or further hole structures (10) are produced in the dividing regions (2) while maintaining an identifiable distance between the holes of the dividing regions (2) and the holes (5) of the individual groups (1), such that the dividing regions (2) remain identifiable compared to the groups (1) of holes (5),
-- the hole structure is filled with a layer sequence of a dielectric (6) and an electrically conductive layer (7) as upper electrode of the semiconductor capacitor to be produced, wherein the layer sequence also extends between the holes (5) and groups (1) and each of the groups (1) forms a first capacitance and
- in a second production phase depending on the semiconductor capacitors to be produced in the semiconductor substrate (4):
-- different subregions (3) of the semiconductor substrate (4) are specified in which semiconductor capacitors having identical capacitance values of the first capacitance are produced in each case, wherein the desired capacitance values of the semiconductor capacitors of the various subregions (3) differ from one another,
-- the layer sequence is structured and a metallization (9) is applied structured or is applied and then structured, wherein the structuring and the application of the metallization are accomplished so that within each subregion (3) the semiconductor capacitors are formed depending on the desired capacitance values either in each case by one of the first capacitances or by electric parallel connection of several of the first capacitances and
-- the semiconductor capacitors of each subregion (3) are separated by separating the semiconductor substrate (4) along dividing lines which run within the dividing regions (2).

2. The method according to claim 1,
**characterized**
**in that** the dividing regions (2) extend rectilinearly over the entire semiconductor substrate (4).

3. The method according to one of claims 1 or 2, **characterized**
**in that** in the first or second production phase a metallization is applied to the semiconductor substrate (4) on the back side.

4. The method according to one of claims 1 to 3, **characterized**
**in that** before the separation of the semiconductor capacitors, the semiconductor substrate (4) is connected to a second semiconductor substrate (11), which has a higher sheet resistance than the semiconductor substrate (4) due to a lower doping so that RC members are obtained by the separation.

5. The method according to one of claims 1 to 3, **characterized**
**in that** before separation of the semiconductor capacitors the semiconductor substrate (4) is provided with a backside layer or layer sequence which has a higher sheet resistance than the semiconductor substrate (4) so that RC members are obtained by the separation.

6. The method according to claim 4 or 5, **characterized**
**in that** in the second production phase a metallization is applied to the second semiconductor substrate on the back side or to the backside layer.

## Revendications

1. Processus de fabrication de condensateurs à semi-conducteurs avec différentes valeurs de capacité dans un substrat semi-conducteur, dans lequel
- dans une première phase de fabrication indépendamment des condensateurs à semi-conducteurs à fabriquer dans le substrat semi-conducteur (4):
-- une structure à trous composée de plusieurs groupes (1) de trous (5) est ménagée dans le substrat semi-conducteur (4), qui sont répartis sur le substrat semi-conducteur (4) et sont chacun séparés les uns des autres par des zones de séparation reconnaissables (2) d'une largeur supérieure à une distance entre les trous (5) à l'intérieur des groupes (1),
dans lequel les zones de séparation (2) soit ne présentent pas de trous, soit d'autres structures de trous (10) sont ménagées dans les zones de séparation (2) tout en maintenant une distance reconnaissable entre les trous des zones de séparation (2) et les trous (5) des groupes individuels (1), de sorte que les zones de séparation (2) restent reconnaissables par rapport aux groupes (1) de trous (5), et
-- la structure de trous avec une séquence de couches composée d'un diélectrique (6) et d'une couche électriquement conductrice (7) est remplie en tant qu'électrode supérieure du condensateur à semi-conducteurs à produire, dans lequel la séquence de couches s'étend également entre les trous (5) et les groupes (1) et chacun des groupes (1) forme une première capacité, et
- dans une deuxième phase de fabrication, en fonction des condensateurs à semi-conducteurs à fabriquer dans le substrat semi-conducteur (4):
-- différentes sous-zones (3) du substrat semi-conducteur (4) sont déterminées, dans chacune desquelles des condensateurs à semi-conducteurs avec des valeurs de capacité identiques à la première capacité peuvent être produits, dans lequel les valeurs de capacité des condensateurs à semi-conducteurs des différentes sous-zones (3) diffèrent l'une de l'autre,
-- la séquence de couches est structurée et une métallisation (9) est appliquée ou appliquée de manière structurée puis structurée, dans lequel la structuration et l'application de la métallisation sont effectuées de telle sorte que les condensateurs à semi-conducteurs dans chaque sous-zone (3) en fonction des valeurs de capacité souhaitées soient formés soit par l'une des premières capacités, soit par une connexion électriquement parallèle de plusieurs des premières capacités, et
-- les condensateurs à semi-conducteurs de chaque sous-zone (3) sont séparés en séparant le substrat semi-conducteur (4) le long de lignes de division qui s'étendent dans les régions de séparation (2).

2. Procédé selon la revendication 1,
**caractérisé en ce que**
les zones de séparation (2) s'étendent en ligne droite sur tout le substrat semi-conducteur (4).

3. Procédé selon la revendication 1 ou 2, **caractérisé en ce que**
dans la première ou la deuxième phase de production, une métallisation est appliquée à l'arrière du substrat semi-conducteur (4).

4. Procédé selon une des revendications 1 à 3, **caractérisé en ce que**
le substrat semi-conducteur (4) avant la séparation des condensateurs à semi-conducteurs est connecté à un deuxième substrat semi-conducteur (11), qui a une résistance de surface plus élevée que le substrat semi-conducteur (4) en raison d'un dopage plus faible, de sorte que des éléments RC soient obtenus par la séparation.

5. Procédé selon une des revendications 1 à 3, **caractérisé en ce que**
le substrat semi-conducteur (4) avant la séparation des condensateurs à semi-conducteurs est pourvu d'une couche arrière ou d'une séquence de couches, qui a une résistance de surface plus élevée que le substrat semi-conducteur (4), de sorte que des éléments RC soient obtenus par la séparation.

6. Procédé selon la revendication 4 ou 5, **caractérisé en ce que**
dans la deuxième phase de production, une métallisation est appliquée à l'arrière du deuxième substrat semi-conducteur ou de la couche arrière.
